# EUROPEAN PATENT APPLICATION

(11) **EP 2 942 744 A1**
(43) Date of publication of application: **11.11.2015**
(21) Application number: 15161688.5
(22) Date of filing: 30.03.2015
(51) Int. Cl.: G06Q 10/06

(54) **A METHOD FOR EVALUATING A PERFORMANCE PREDICTION FOR A WIND FARM**

(30) Priority: 31.03.2014 US 201414230801
(71) Applicant: Vestas Wind Systems A/S, 8200 Aarhus N (DK)
(72) Inventor: Knudsen, Sven Jesper, 6800 Varde (DK); Andersen, Kim Emil, 9000 Aalborg (DK)
(74) Representative: Vestas Patents Department

(57) **Abstract**

A method for evaluating a performance prediction for a wind farm comprising a plurality of wind turbines is disclosed. The method comprises providing a siting model, said siting model being capable of predicting performance of a wind farm, based on performance estimates of individual wind turbines forming part of the wind farm; applying the siting model to one or more existing wind farms, thereby predicting performance of the existing wind farm(s); and comparing the predicted performance of the existing wind farm(s) to historical performance data of the existing wind farm(s). The performance prediction provided by the siting model is evaluated, based on the comparing step.

## Description

### FIELD OF THE I NVENTI ON

The present invention relates to a method for evaluating a performance prediction for a wind farm. The method may be used for benchmarking a siting model with respect to its ability to predict performance of a wind farm, e.g. against other models. Based on the evaluation, a suitable siting model may be selected for use in a siting process for a new wind farm.

### BACKGROUND OF THE I NVENTI ON

When a new wind farm is planned, a number of investigations are normally performed at the site of the wind farm. Furthermore, the positions of the individual wind turbines within the site are planned, in order to provide an optimum power output, and thereby an optimum return of investment, from the wind farm. During this process, a performance prediction is often calculated, e.g. including a forecast of the expected power production of the wind farm. To this end, a siting model is used.

Once the wind farm has been constructed, it is possible to compare the predicted performance of the wind farm to the actual performance of the wind farm. However, it is desirable to know how accurate a performance prediction provided by a siting model is, before the wind farm is actually constructed, in particular while taking local conditions, such as wind conditions, weather conditions, and landscape variations, into consideration, since this will allow a siting engineer to select the best available siting model.

US 2012/0144237 A1 discloses a method of efficacy anticipation and failure examination for an apparatus. The method first establishes an anticipation model, and then trains the anticipation model by calibrating the same using errors obtained between a realistic data and an anticipated data, so as to use the calibrated anticipation model to estimate the performance efficacy of an apparatus.

US 2011/0224926 A1 discloses a method for use in calculating a possible power output of a wind turbine. A series of performance data samples is acquired. Each performance data sample includes a meteorological condition and a power output indicated at a first time by one or more sensors associated with the wind turbine. A transfer function is calculated based at least in part on the series of performance data samples. The transfer function relates power output to the meteorological condition. A possible power output is calculated based on the transfer function and at least one meteorological condition indicated by the one or more sensors at a second time.

US 6,975,925 B1 discloses a method for forecasting an energy output of a wind farm, including maintaining a database of wind patterns, each wind pattern being associated with an energy output that the wind farm produces. The method includes receiving a current wind pattern, searching the database for a wind pattern that matches the current wind pattern, and calculating a forecast energy output that the wind farm will produce in response to the current wind pattern, based on the energy output of the matching wind pattern.

Common to the methods disclosed in the documents mentioned above is that none of them allows the predictions provided by the methods to be evaluated or benchmarked.

### DESCRIPTI ON OF THE I NVENTI ON

It is an object of embodiments of the invention to provide a method for evaluating a performance prediction of a wind farm, which allows the performance prediction to be benchmarked.

It is a further object of embodiments of the invention to provide a method which allows a performance prediction in a siting process of a wind farm to be accurately provided.

According to a first aspect the invention provides a method for evaluating a performance prediction for a wind farm, said wind farm comprising a plurality of wind turbines, the method comprising the steps of:
- providing a siting model, said siting model being capable of predicting performance of a wind farm, based on performance estimates of individual wind turbines forming part of the wind farm,
- applying the siting model to one or more existing wind farms, thereby predicting performance of the existing wind farm(s), to provide a performance prediction,
- comparing the predicted performance of the existing wind farm(s) to historical performance data of the existing wind farm(s), and
- evaluating the performance prediction provided by the siting model, based on the comparing step, to provide a performance evaluation.

The method of the invention is for evaluating performance prediction for a wind farm. In the present context the term 'wind farm' should be interpreted to mean a collection of a plurality of wind turbines arranged at a site. The wind turbines of the wind farm may advantageously be partly controlled centrally in order to control the total energy production of the wind farm.

It is not uncommon to attempt to predict, estimate or forecast the performance of a wind farm. This may, e.g., be done as a part of a siting process, i.e. a process which is performed when the construction of the wind farm is planned. In this case the performance prediction may be used in a decision process in which it is determined whether or not it is feasible to construct the wind farm, which kinds of turbines to use in order to obtain a reasonable return of investment, etc. Alternatively or additionally, the performance prediction may be performed after the wind farm has been constructed, e.g. in order to predict expected income and costs within a specific time period, such as the next year or the next 5 years.

The performance being predicted may, e.g., include power output, wind speed at the site, various loads on the wind turbines, degrading of wind turbine blades, service and maintenance costs, down time due to service and maintenance, etc.

According to the invention, the performance prediction provided by a specific siting model is evaluated or benchmarked. This may result in a measure for how accurate the performance prediction is, e.g. taking specific conditions of the site into consideration. This will be described in further detail below.

According to the method of the invention, a siting model is initially provided. In the present context the term 'siting model' should be interpreted to mean a model which is used when planning construction of a new wind farm. Siting models are usually used for planning the number and kind of wind turbines to be used for the wind farm, as well and the positioning of the wind turbines within the site, in such a manner that an optimal return of investment can be obtained by the owners of the wind farm. To this end, the siting model is capable of the predicting performance of the wind farm, e.g. including calculating an expected yearly power output or power production of the wind farm.

According to the method of the invention, the provided siting model is capable of predicting performance of the wind farm, based on performance estimates of individual wind turbines forming part of the wind farm. Thus, the siting model is not merely capable of providing total estimate of the performance of the entire wind farm, reflecting some kind of average performance of the wind turbines, but is capable of taking individual considerations of each of the wind turbines of the wind farm into consideration when the expected performance of the wind farm is calculated. This is an advantage because it provides a more accurate performance prediction, and because it is possible to break down the analysis of the performance in order to identify which parts or components of the siting model gives rise to potential deviations between a predicted performance and an actual performance of a wind farm. This allows the siting model to be adjusted with respect to such parts or components, thereby improving the performance prediction provided by the siting model. This will be described in further detail below.

Next, the provided siting model is applied to one or more existing wind farms. Thereby, for each of the existing wind farm(s), an expected performance is predicted by means of the siting model. The performance(s) predicted in this manner is/are then compared to actual, historical performance data originating from the existing wind farm(s). This provides, for each of the existing wind farm(s), a measure for the accuracy of the performance prediction provided by the siting model, under the specific conditions prevailing at the existing wind farm(s). The performance being compared could, e.g., be power production, but it may also include other parameters, such as various loads on the wind turbines or wind conditions. The comparison to historical data may include long term correction of the historical data.

Finally, the performance prediction provided by the siting model is evaluated, based on the comparing step. Thereby an evaluation, or benchmark, of the siting model's ability to predict performance of the wind farm is obtained. This is an advantage, because it can thereby easily be determined whether or not a given siting model is suitable for use when a new wind farm is planned, e.g. taking specific conditions prevailing at the site of the new wind farm into consideration. Furthermore, it is an advantage that the obtained evaluation is performed on a siting model which is capable of predicting performance of a wind farm, based on performance estimates of individual wind turbines forming part of the wind farm, because this allows individual components of the siting model, such as individual turbines, wake conditions, landscape conditions etc., to be evaluated separately, and thereby it may be possible to determine which parts of a siting model gives rise to deviations between predicted and actual performance of a wind farm. This will be described in further detail below.

The evaluation may, e.g., include evaluating the siting model's ability to predict performance of the entire wind farm, or performance of the individual wind turbines forming part of the wind farm. Alternatively or additionally, the evaluation may include calculating a risk factor, indicating the risk of making an incorrect prediction with respect to the performance of the wind farm. Calculation of such a risk factor may, e.g., be based on a variance of performance predictions relating to individual wind turbines across the wind farm. A siting model may be good at predicting performance on average, but have a high variance. This indicates that the model is accurate, but risky. Another siting model may be inaccurate, but precise. By subtracting the bias, the accuracy can be adjusted. Since the siting models used for performing the method of the invention are based on performance of individual wind turbines, it may even be possible to identify drivers of risk. This is a great advantage.

The performance prediction provided by the siting model may further be based on local conditions at the site(s) of the wind farm(s). The local conditions may, e.g., include prevailing wind conditions at the site and/or variations in prevailing wind conditions across the site, prevailing whether conditions at the site, wake conditions across the site, e.g. including possible forest arranged within the site, relative positions of the wind turbines, etc., landscape variations within the site, e.g. including hills and valleys, etc. Furthermore, the performance prediction may be adjusted according to a performance benchmark risk model based on local conditions at the site of the wind farm.

Alternatively or additionally, the performance prediction provided by the siting model may further be based on the type(s) of wind turbines forming part of the wind farm.

The method may further comprise the step of determining whether or not to apply the siting model for a new wind farm, based on the evaluating step. According to this embodiment, once the prediction performance of a siting model has been evaluated, it is possible to determine whether or not that siting model will be suitable with respect to predicting performance of a new wind farm being planned. For instance, the evaluating step may reveal that the siting model is exceptionally good at predicting performance of wind farms arranged at sites with forest, but not particularly good at predicting performance of wind farms arranged at sites with high prevailing wind speeds, high precipitation levels, offshore sites or sites with complex terrain. In this case, if the new wind farm, which is planned, is to be arranged at a site with forest, then the siting model may be suitable with respect to projecting the new wind farm. On the other hand, if the new wind farm is to be arranged at a site with high prevailing wind speeds, high precipitation levels, offshore or at a site with complex terrain, then another siting model should probably be selected instead.

According to this embodiment, the evaluation of the performance prediction of the siting model is actively used for selecting a siting model, such as a siting model with a suitable associated risk, when a new wind farm is planned. Thereby it is obtained that the performance prediction provided for new wind farms is improved, e.g. in terms of being more accurate and/or having a lower risk.

The method may further comprise the steps of:
- providing one or more further siting models, said siting further model(s) being capable of predicting performance of a wind farm, based on performance estimates of individual wind turbines forming part of the wind farm,
- applying each of the further siting models to one or more existing wind farms, thereby, for each of the further siting models, predicting performance of the existing wind farm(s), to provide performance prediction,
- comparing the predicted performance, by each of the further siting models, of the existing wind farm(s) to historical performance data of the existing wind farm(s), and
- evaluating the performance predictions provided by each of the further siting models, based on the comparing step, to provide a performance evaluation.

According to this embodiment, the performance predictions of two or more siting models are evaluated in the manner described above. When a new wind farm is subsequently planned, there will be a range of evaluated siting models available, and this will make it easier to choose an appropriate siting model for the new wind farm, e.g. based on accuracy and/or risk.

The method may further comprise the steps of:
- comparing the performance predictions provided by the siting models,
- selecting one of the siting models, based on the comparing step, and
- applying the selected siting model for a new wind farm.

According to this embodiment, the evaluated performance predictions of the siting models are compared. This provides a direct benchmark of the siting models relative to each other, with respect to their ability to predict performance of a wind farm. This makes it very easy to select the siting model which is best suited under the given circumstances, when a new wind farm is planned.

The siting models being compared in this manner may differ, e.g. with respect to choice of wind turbine types, how effects originating from site conditions and/or meteorological conditions are taken into account. Site conditions could, e.g., include site complexity and obstacles, such as forest, neighbouring wind farms or wind turbines, hills and valleys, etc. Meteorological conditions could, e.g., include wind conditions, such as prevailing wind speeds, prevailing wind direction, turbulence, wind shear, atmospheric instability, etc. When the performance predictions provided by each of the siting models are evaluated, as described above, the existing wind farms used for this purpose may advantageously be chosen in such a manner that they are similar to the planned new wind farm. For instance, wind conditions and choice of wind farm type may vary significantly according to geographical position, particulars of the landscape, whether the wind farm is arranged onshore or offshore, etc. When the performance predictions of the siting models are evaluated, based on the same existing wind farms, and the existing wind farms are similar to the planned new wind farm, e.g. in terms of site conditions and/or meteorological conditions, as defined above, the comparison of the performance predictions provides direct information regarding which of the siting models is best suited with respect to predicting performance of a wind farm under the conditions prevailing at the site of the planned new wind farm. This is a great advantage.

The method may further comprise the steps of:
- building a new siting model, based on two or more of the previous siting models, and in accordance with the evaluated performance predictions, and
- applying the new siting model for a new wind farm.

According to this embodiment, none of the existing siting models is selected for the new wind farm. Instead, a new siting model is built, taking the best of all or some of the existing siting models. For instance, the evaluations of the performance predictions of the siting models may reveal that one of the siting models is very good at predicting performance of a wind farm at a site with forest, and that another one of the siting models is very good at predicting performance of a wind farm at a site where turbulence is very likely to occur. If the new wind farm is planned at a site with forest, and where turbulence is very likely to occur, a new siting model may be built which applies the part of the first siting model, which relates to calculating the effects of forest, and the part of the second siting model, which relates to calculating the effects of turbulence. Thereby the new siting model can be expected to be able to provide accurate and/or low risk performance predictions of the new wind farm, and it is therefore a suitable choice for use in the siting process of the new wind farm. The new siting model may be regarded as an ensemble model.

The method may further comprise the step of identifying one or more components of the siting model, which is/are responsible for deficiencies between predicted performance and historical performance data. The components being identified could, e.g., be a part of the siting model which handles effects caused by specific wind conditions, such as turbulence, wind shear, high wind speeds, low wind speeds, etc., a part of the siting model which handles effects caused by the presence of forest, a part of the siting model which handles effects caused by variations in the landscape, such as hills and valleys, a part of the siting model which handles wake effects, a part of the siting model which relates to the kinds of wind turbines selected for a site, etc.

According to this embodiment, the performance prediction provided by the siting model is analysed in the sense that it can be determined which parts of the siting model are responsible for the deficiencies occurring in the final performance prediction of the siting model, and which parts of the siting model do not contribute to the final deficiencies. Once the loss or risk drivers have been identified, it is possible to improve the siting model with respect to these components of the siting model, thereby improving the final performance prediction provided by the siting model.

Even if a number of components of the siting model are identified as giving rise to deficiencies between the predicted performance and the historical performance, there may still be a part of the deficiencies of the final performance prediction which are unaccounted for. Such unaccounted deficiencies may be regarded as representing a risk factor of the siting model, i.e. a risk of making wrong or erroneous performance predictions with respect to new wind farms.

The method may further comprise the step of adjusting one or more of the identified components of the siting model, thereby obtaining an improved siting model, as described above.

The step of comparing the predicted performance of the existing wind farm(s) to historical performance data of the existing wind farms may comprise providing a long time correlation of the historical performance data.

The existing wind farm(s) used for evaluating the performance prediction of the siting model may only have been operational for a limited period of time, or performance data may only exist for a limited period of time. In order to extend historical data to a longer period of time, long time correlation of data is sometimes applied. To this end, mesoscale data relating to global weather data, stored in a large database, and/or data obtained from weather stations, such as weather stations at airports, are used for calculating how the wind farm would have performed during the period of time covered by the mesoscale data, based on the actual data obtained during the limited period of time. Thereby a more accurate evaluation of the performance prediction provided by the siting model can be provided.

The steps of the method may be performed automatically in response to initiation of a siting process for a new wind farm. In this case, the evaluation of one or more siting models is an integrated part of the siting process, when a new wind farm is planned. As an alternative, the steps of the method may be performed more or less continuously. In this case a benchmark of the available siting models is always available when a siting process is initiated. Furthermore, siting personnel can continuously review the performance of their siting models. As another alternative, the steps of the method may be initiated when a new siting model has been built, in order to benchmark this siting model, e.g. against existing siting models.

The method of the first aspect of the invention may be implemented on a single computer or a selection of computing units, which each may be a separate computer, but interconnected to perform the collected method.

According to a second aspect the invention provides a system of computing units for evaluating a performance prediction for a wind farm, said wind farm comprising a plurality of wind turbines, the system comprising:
- a computing unit for providing a siting model, said siting model being capable of predicting performance of a wind farm, based on performance estimates of individual wind turbines forming part of the wind farm,
- a computing unit for applying the siting model to one or more existing wind farms, thereby predicting performance of the existing wind farm(s), to provide a performance prediction,
- a computing unit for comparing the predicted performance of the existing wind farm(s) to historical performance data of the existing wind farm(s), and
- a computing unit for evaluating the performance prediction provided by the siting model, based on the comparing step, to provide a performance evaluation.

The system according to the second aspect of the invention is capable of performing the method according to the first aspect of the invention. The remarks set forth above with reference to the first aspect of the invention are therefore equally applicable here.

### BRI EF DESCRI PTI ON OF THE DRAWINGS

The invention will now be described in further detail with reference to the accompanying drawings, in which
Fig. 1 is a block diagram illustrating a method according to an embodiment of the invention,
Fig. 2 is a flow diagram illustrating a method according to a first embodiment of the invention, and
Fig. 3 is a flow diagram illustrating a method according to a second embodiment of the invention.

### DETAILED DESCRI PTI ON OF THE DRAWINGS

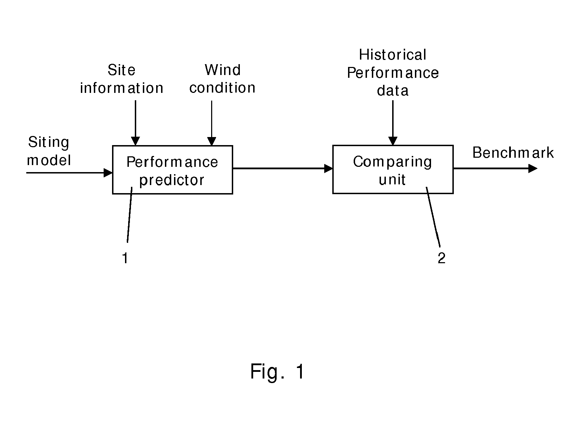

Fig. 1 is a block diagram illustrating a method according to an embodiment of the invention. A siting model is supplied to a performance predictor 1. The siting model is a tool which is used when a new wind farm is planned at a specific site. The siting model is preferably capable of calculating an expected yearly power output of the wind farm, based on the number of wind turbines, the types of wind turbines used, the arrangement of the wind turbines within the site, local prevailing wind conditions, local landscape conditions, etc.

Site information and information regarding local wind conditions relating to a site of an existing wind farm are also supplied to the performance predictor 1. The site information could, e.g., include information regarding the geographical location of the wind farm, the number and types of wind turbines of the wind farm, the arrangement of the wind turbines within the site, information regarding whether or not there is forest at the site, information regarding the landscape at the site, such as hills and valleys, etc. The information regarding local wind condition could, e.g., include information regarding prevailing wind directions, prevailing wind speeds, risk of turbulence, risk of wind shear, amount and kind of precipitation, prevailing temperatures, prevailing humidity levels, etc.

Based on the received information, and using the provided siting model, the performance predictor 1 calculates an expected performance of the wind farm, i.e. the performance predictor 1 predicts the performance of the wind farm. The predicted performance could, e.g., include an expected yearly power production of the wind farm, expected yearly power production of the individual wind turbines forming part of the wind farm, various loads on the wind turbines forming part of the wind farm, expected maintenance on the wind turbines forming part of the wind farm, expected wind conditions at the position of each of the wind turbines, etc.

The predicted performance is supplied to a comparing unit 2. Historical performance data relating to the existing wind farm is also supplied to the comparing unit 2. The historical performance data is actual data which has been measured at the existing wind farm, and thereby the historical performance data represents the actual performance of the wind farm. Furthermore, the historical performance data corresponds to the predicted performance which is calculated by the performance predictor 1. Thereby the comparing unit 2 can directly compare the predicted performance to the historical performance data, and this comparison reveals how good the siting model is at predicting the performance of the wind farm. Accordingly, the comparing unit 2 outputs a benchmark or an evaluation which indicates how good the performance prediction of the siting model is, e.g. in terms of the accuracy of the performance prediction, as described above.

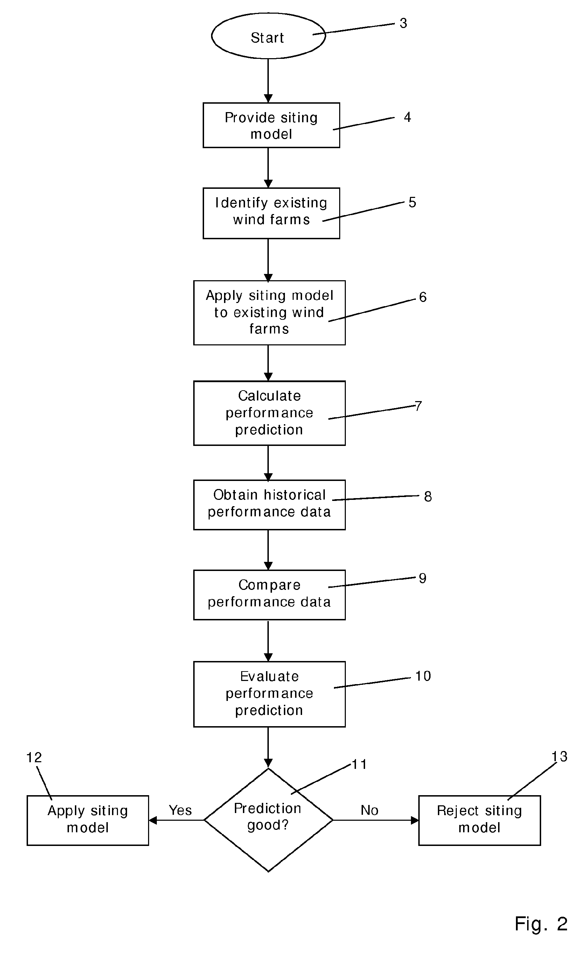

Fig. 2 is a flow diagram illustrating a method according to a first embodiment of the invention. The process is started at step 3. At step 4 a siting model is provided. The siting model may, e.g., be built directly, or it may be selected among a number of available siting models. Next, at step 5, an existing wind farm is identified. The existing wind farm may, e.g., be a wind farm which is arranged at a site which is similar to a site where a new wind farm is planned, as described above.

At step 6 the siting model is applied to the existing wind farm. This results in a performance prediction for the existing wind farm being calculated, by means of the siting model, at step 7.

At step 8 historical performance data of the existing wind farm is obtained, e.g. from a database. The historical performance data represents actual performance of the existing wind farm. The historical performance data corresponds to the predicted performance, and the predicted performance is therefore directly comparable to the historical performance data. Thus, at step 9 the predicted performance data is compared to the historical performance data, and the performance prediction of the siting model is evaluated, based on the comparison, at step 10. For instance, if the comparison reveals that the predicted performance deviates significantly from the historical performance data, then it can be concluded that the performance prediction provided by the siting model is poor. On the other hand, if the comparison reveals that the predicted performance does not deviate, or only deviates insignificantly, from the historical performance data, then it can be concluded that the performance prediction provided by the siting model is good.

At step 11 it is investigated whether or not the siting model is a suitable siting model, under the given circumstances. This is based on the result of the evaluation performed at step 10. If it is determined at step 11 that the siting model is a suitable siting model, then the process is forwarded to step 12, and the siting model is applied in the siting process of a new wind farm. In the case that it is determined at step 11 that the siting model is not a suitable siting model, then the process is forwarded to step 13, and the siting model is rejected. The process may then be returned to step 4 in order to evaluate another siting model.

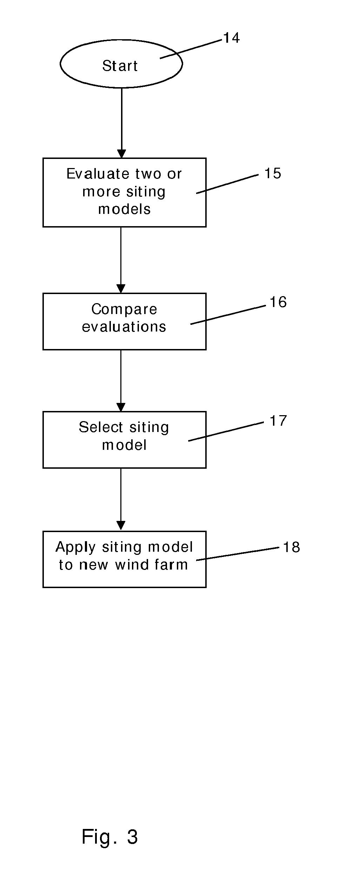

Fig. 3 is a flow diagram illustrating a method according to a second embodiment of the invention. The process is started at step 14. At step 15 two or more siting models are evaluated, with respect to their ability to predict performance of a wind farm. Step 15 may, e.g., be performed in the manner described above with reference to Fig. 2.

At step 16 the performance predictions provided by each of the siting models are compared. This comparison reveals which of the siting models is best suited for predicting performance of a wind farm, under the given circumstances.

At step 17, one of the siting models is selected, based on the comparison of step 16. The selected siting model may, e.g., be the one which is capable of providing the most accurate prediction of the performance of a wind farm.

Finally, the selected siting model is applied to the siting process of a new wind farm, at step 18.

## Claims

1. A method for evaluating a performance prediction for a wind farm, said wind farm comprising a plurality of wind turbines, the method comprising the steps of:
- providing a siting model, said siting model being capable of predicting performance of a wind farm, based on performance estimates of individual wind turbines forming part of the wind farm,
- applying the siting model to one or more existing wind farms, thereby predicting performance of the existing wind farm(s), to provide a performance prediction,
- comparing the predicted performance of the existing wind farm(s) to historical performance data of the existing wind farm(s), and
- evaluating the performance prediction provided by the siting model, based on the comparing step, to provide a performance evaluation.

2. A method according to claim 1, wherein the performance prediction provided by the siting model is further based on local conditions at the site(s) of the wind farm(s).

3. A method according to claim 1 or 2, further comprising the step of determining whether or not to apply the siting model for a new wind farm, based on the evaluating step.

4. A method according to any of the preceding claims, further comprising the steps of:
- providing one or more further siting models, said further siting model(s) being capable of predicting performance of a wind farm, based on performance estimates of individual wind turbines forming part of the wind farm,
- applying each of the further siting models to one or more existing wind farms, thereby, for each of the siting models, predicting performance of the existing wind farm(s), to provide a performance prediction,
- comparing the predicted performance, by each of the siting models, of the existing wind farm(s) to historical performance data of the existing wind farm(s), and
- evaluating the performance predictions provided by each of the siting models, based on the comparing step, to provide a performance evaluation.

5. A method according to claim 4, further comprising the steps of:
- comparing the performance predictions provided by the siting models,
- selecting one of the siting models, based on the comparing step, and
- applying the selected siting model for a new wind farm.

6. A method according to claim 4, further comprising the steps of:
- building a new siting model, based on two or more of the previous siting models, and in accordance with the evaluated performance predictions, and
- applying the new siting model for a new wind farm.

7. A method according to any of the preceding claims, further comprising the step of identifying one or more components of the siting model, which is/are responsible for deficiencies between predicted performance and historical performance data.

8. A method according to claim 7, further comprising the step of adjusting one or more of the identified components of the siting model.

9. A method according to any of the preceding claims, wherein the step of comparing the predicted performance of the existing wind farm(s) to historical performance data of the existing wind farms comprises providing a long time correlation of the historical performance data.

10. A system of computing units for evaluating a performance prediction for a wind farm, said wind farm comprising a plurality of wind turbines, the system comprising:
- a computing unit for providing a siting model, said siting model being capable of predicting performance of a wind farm, based on performance estimates of individual wind turbines forming part of the wind farm,
- a computing unit for applying the siting model to one or more existing wind farms, thereby predicting performance of the existing wind farm(s), to provide a performance prediction,
- a computing unit for comparing the predicted performance of the existing wind farm(s) to historical performance data of the existing wind farm(s), and
- a computing unit for evaluating the performance prediction provided by the siting model, based on the comparing step, to provide a performance evaluation.
